# EUROPEAN PATENT APPLICATION

(11) **EP 1 035 566 A2**
(43) Date of publication of application: **13.09.2000**
(21) Application number: 00102941.2
(22) Date of filing: 14.02.2000
(51) Int. Cl.: H01L 21/266, H01L 21/74

(54) **Method for forming a buried doped layer with connecting portions within a semiconductive device**

(30) Priority: 03.03.1999 US 261527
(71) Applicant: Infineon Technologies North America Corp., San Jose, CA 95112-6000 (US)
(72) Inventor: Radius, Roland F., Wappingers Falls, NY 12590 (US); Hieke, Andreas, Wappingers Falls, NY 12590 (US)
(74) Representative: Patentanwälte Westphal, Mussgnug & Partner

(57) **Abstract**

A method for forming a buried implanted layer in a semiconductive substrate that includes a tapered edge portion that extends to the surface of the substrate and uses a mask having a tapered edge to define the area of implantation.

## Description

### Field of Invention

This invention relates to the manufacture of semiconductive devices and, more particularly, to devices that use a buried region of one conductivity type to which a low resistance connection is to be made from the top surface, typically by a region of like conductivity that extends from the top surface to the buried region.

### Background of the Invention

In current semiconductor devices there is often the need to connect to a buried layer of one conductivity type in a semiconductive region of the opposite conductivity type by a connecting region, or contact, that extends from a top surface of the semiconductive region to the buried layer. An example of such a structure is that of a bathtub shaped region of one conductivity that extends from a top surface of a silicon chip into the bulk of the chip, which bulk is of the opposite conductivity type. The relatively flat or base portion of the tub-shaped region may be viewed as the buried layer and the sides, or periphery, of the tub-shaped region as a connecting portion, or contact, that extends from the buried base layer to the top surface of the chip.

At the current state of the art, in such chips, the buried layer is generally formed by the implantation of high energy ions that penetrate the surface of the chip and largely come to rest forming a buried layer relatively deep in the chip. There, after appropriate annealing, these ions form a buried layer of a conductivity type determined by the type of ion implanted. Then, in such cases, the connecting portion to the surface of the chip is generally formed by a series of implantations, of the same type as those used for the buried layer, but localized by masking to the periphery of the buried layer and at successively lower energies to form implanted regions of lower depth.

This technique has the disadvantage that it requires a number of implantations at different energies and the mask used to form the deep implantation for the buried layer and the mask used for the lower energy implantations to form the connecting region must be different. Thus two MASKS are needed. Moreover, this technique typically requires that the connecting region use a significant amount of surface area, which is another disadvantage when it is desired to maximize the density of components in the chip.

The present invention provides a simple technique to achieve substantially the same doped configuration with only a single mask.

### Summary of The Invention

It has been found by computer simulation techniques that the desired full tub-shaped configuration can be obtained essentially with a single mask and a single high energy implantation by properly tapering the edge of the mask, usually of a photoresist material, that is used to define the ion implantation that forms the buried layer. In particular, by properly tapering the edge of the mask, there can be formed in the region of the chip underlying the tapered region of the mask, a concentration of implanted ions that, when appropriately annealed, will form a tapered continuous region, of the conductivity type characteristic of the implanted ion, and that extends from the top surface of the chip to the deeply buried layer.

Viewed from a method aspect, the present invention is directed to a method for forming in a semiconductive region of one conductivity type a buried layer of the opposite conductivity type that extends at least in part continuously to the top surface by implanting the region with an ion beam characteristic of said opposite conductivity type through an opening in an implantation mask having a tapered edge which defines the opening such that the implanted layer comprises a tapered portion corresponding to the taper edge of the mask.

Viewed from an other method aspect, the present invention is directed to a method for forming in a semiconductive region of one conductivity type a buried layer of the same conductivity type, but of higher impurity concentration, that extends at least in part continuously to the top surface by implanting the region with an ion beam characteristic of the same conductivity type through an opening in an implantation mask having a tapered edge which defines the opening such that the implanted layer comprises a tapered portion corresponding to the taper edge of the mask.

Viewed from a product by process aspect, the present invention is directed to a semiconductive region of one conductivity type having a buried layer of the opposite conductivity formed therein with the buried layer having a tapered portion which extends to a top surface of the semiconductive region with the buried layer being formed by ion implanting of impurities of the opposite conductivity type through an opening in a mask comprising an edge which is tapered and defines the opening.

Viewed from an other product by process aspect, the present invention is directed to a semiconductive region of one conductivity type having a buried layer of the same conductivity, but of higher impurity concentration, formed therein with the buried layer having a tapered portion which extends to a top surface of the semiconductive region with the buried layer being formed by ion implanting of impurities of the same conductivity type through an opening in a mask comprising an edge which is tapered and defines the opening.

The invention will be better understood from the following more detailed description taken with the accompanying drawing.

### Brief Description of The Drawing

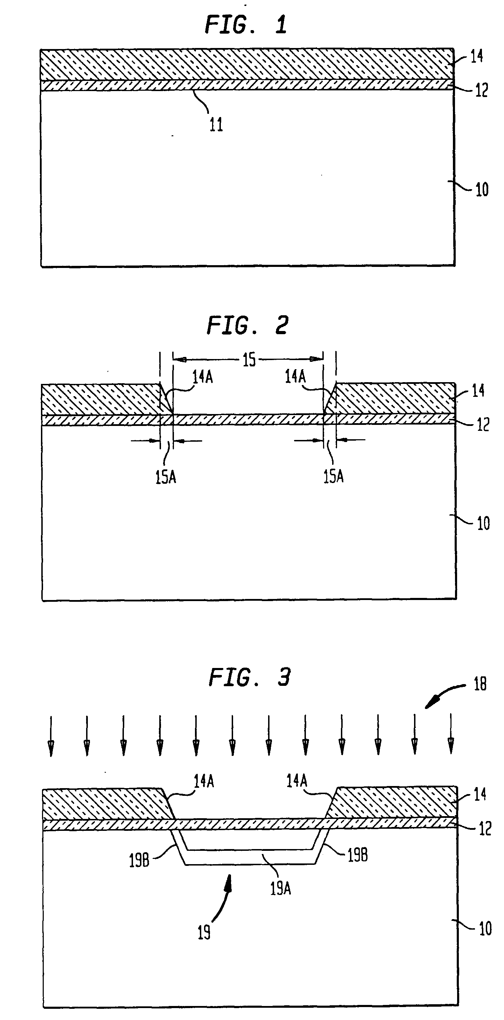

FIGS. 1-3 illustrate different stages of the chip in an illustrative embodiment of the invention used to form a tub-shaped region of one conductivity type in a monocrystalline silicon region of the opposite conductivity type.

### Detailed Description

FIG. 1 shows a cross section of a monocrystalline silicon region 10 of one conductivity type, for example p-type, in which there is to be formed an n-type tub-shaped region that includes a relatively deep flat base portion and a tapered edge (peripheral) portion that extends continuously from the buried base portion to the top surface. The silicon region 10 may be part of a p-type silicon wafer or a p-type silicon layer on any suitable substrate. Similarly, there could be formed a buried layer of p-type conductivity in an n-type region by appropriate choice of the implanted ion. Similarly, there could be formed a buried layer of p-type conductivity with higher impurity concentration than a p-type region in which it is formed or there could be formed an n-type conductivity buried layer with higher impurity concentration than an n-type region in which it is formed.

To achieve these ends, there is first formed over a top surface 11 of the silicon region 10 a customary thin sacrificial oxide layer 12 that primarily serves to protect the silicon surface from damage by the high energy ions to be implanted. In some instances, it may be feasible to omit such layer.

Next there is deposited over the oxide-coated top surface 12 a layer 14 of a material suitable for serving as the mask for localizing the implantation as desired. Typically this is of a suitable photoresist.

Next the mask layer 14 is patterned using standard photolithography to expose completely a central region 15 of the oxide-coated substrate corresponding to the desired buried flat portion of the implanted region surrounded by a peripheral region 15A. An edge 14A of the mask 14 is tapered as is shown in FIG. 2.

Then, as is shown schematically in FIG. 3, the silicon region 10 is exposed to an ion beam 18 for implanting donor-type ions into the silicon region 10. The accelerating voltage of the beam is chosen to provide that the implanted ions will penetrate in the completely exposed central area 15 to a depth that essentially corresponds to the depth desired for a flat portion 19A of the implanted layer 19. The normal spread in the energies of the implanted ions will generally result in a spread in the thickness of the base portion 19A. Alternatively, without changing the mask, the accelerating voltage may be varied to provide a desired thickness to the implanted base portion 19A. In the peripheral region 15A, where the implanted ions impinge on the tapered mask edge 14A and gradually lose energy, the depth of the resulting implanted region 19B will be characterized by a similar taper forming a continuous region that extends from the base portion 19B to the top surface 11 of semiconductive region 10, as is shown in FIG. 3.

Then the silicon is heated in the usual fashion both for annealing the damage done to the silicon by the high energy ions and also for shifting the implanted ions from interstitial sites into appropriate crystal sites where they can be effective in converting the conductivity to n-type. The effect is the conversion of the implanted regions to n-type. If the silicon region 10 is of n-type conductivity, then the formed buried layer 19 can be of p-type conductivity. With the silicon region being of p-type conductivity, the formed buried layer 19 can be of p-type conductivity having a higher impurity concentration than the p-type silicon region 10. With the silicon region being of n-type conductivity, the formed buried layer 19 can be of n-type conductivity having a higher impurity concentration than the n-type silicon region 10.

Moreover, it should also be apparent that the invention can be extended to semiconductors other than silicon, such as germanium or compound semiconductors.

It should also be apparent that the geometry of the implanted region can be modified as desired by appropriately shaping the opening in the mask used to localize the implantation. Similarly, it should be apparent that the tapered portion of the implanted region chat extends to the top surface need not extend around the entire perimeter of the deep flat portion of the implanted region but may be localized to just a portion of the perimeter by appropriately tapering only a portion of the mask edge.

## Claims

1. A method for forming in a semiconductive region of one conductivity type a buried layer of the opposite conductivity type that extends at least in part continuously to the top surface by implanting the region with an ion beam characteristic of said opposite conductivity type through an opening in an implantation mask having a tapered edge which defines the opening such that the implanted layer comprises a tapered portion corresponding to the taper edge of the mask.

2. The method of claim 1 used to form in the semiconductive region a tub-shaped layer of the opposite conductivity type by tapering the entire periphery of the opening in the mask.

3. The method of claim 1 in which the ion implantation is done at an essentially constant accelerating voltage.

4. The method of claim 1 in which the ion implantation is done through the same mask over a range of accelerating voltages to provide additional thickness to the implanted layer.

5. The method of claim 1 in which the semiconductor region is a portion of a monocrystalline silicon substrate.

6. The method of claim 1 in which the region being implanted includes over its top surface a sacrificial layer of silicon oxide to protect the top surface from damage by the implantation.

7. A method for forming in a semiconductive region of one conductivity type a buried layer of the same conductivity type, but of higher impurity concentration, that extends at least in part continuously to the top surface by implanting the region with an ion beam characteristic of the same conductivity type through an opening in an implantation mask having a tapered edge which defines the opening such that the implanted layer comprises a tapered portion corresponding to the taper edge of the mask.

8. A semiconductive region of one conductivity type having a buried layer of the opposite conductivity formed therein with the buried layer having a tapered portion which extends to a top surface of the semiconductive region with the buried layer being formed by ion implanting of impurities of the opposite conductivity type through an opening in a mask comprising an edge which is tapered and defines the opening.

9. A semiconductive region of one conductivity type having a buried layer of the same conductivity, but of higher impurity concentration, formed therein with the buried layer having a tapered portion which extends to a top surface of the semiconductive region with the buried layer being formed by ion implanting of impurities of the same conductivity type through an opening in a mask comprising an edge which is tapered and defines the opening.
